Europäisches Patentamt

European Patent Office

Office européen des brevets

(19)

(11) Publication number: 0 483 965 A2

# EUROPEAN PATENT APPLICATION

(21) Application number: 91308399.4

(22) Date of filing: 13.09.91

(51) Int. Cl.5: G06F 15/60

(30) Priority: 30.10.90 US 605900

(43) Date of publication of application:
06.05.92 Bulletin 92/19

(84) Designated Contracting States:
DE FR GB

(71) Applicant: International Business Machines
Corporation
Old Orchard Road
Armonk, N.Y. 10504(US)

(72) Inventor: Romero, Hector Gerardo, Jr.
12229 Antoinette Place
Austin, Texas 78727(US)
Inventor: Somyak, Thomas James
9722 Anderson Village Drive
Austin, Texas 78729(US)
Inventor: Wright, Charles Gordon
1204 Woodrock
Round Rock, Texas 78681(US)

(74) Representative: Killgren, Neil Arthur
IBM United Kingdom Limited Intellectual
Property Department Hursley Park
Winchester Hampshire SO21 2JN(GB)

(54) Logic simulation.

(57) A logic simulation machine including multiple simulation processors 2A, 2B for executing logic simulation in parallel and a memory 23 coupled to each processor for storing a current state description of a digital logic circuit being simulated. Each memory stores state description information in a first portion 23A updated by the associated simulation processor and a second portion 23B updated by remaining simulation processors.

FIG. 1

Rank Xerox (UK) Business Services
(-/2.17/2.1)

The present invention relates to logic simulation.

Logic technologies such as very large scale integrated circuits provide significant improvements in cost/performance and reliability. However, they have disadvantages in that their fault diagnosis is more difficult than previous technologies and their engineering rework cycles needed to correct faults in logic design are greatly lengthened. These disadvantages exact great economic penalties for design errors and omissions and place a great emphasis on the goal of completely verifying designs in advance of engineering models.

One technique for providing design verification is logic simulation by a general purpose computer. Another technique is to use a special purpose computer that is optimized for logic simulation. The special purpose computer usually uses a multiple processor architecture by which a number of processors, called simulation processors, may be interconnected to improve simulation performance. The special purpose computer may operate in combination with a host computer which is used to provide loading functions and to analyze the results of the simulation. Such a special purpose computer is called a logic simulation machine. The present invention relates to the logic simulation machine.

A prior art logic simulation machine is described in U.S. Pat. No. 4,306,286 issued December 15, 1981, to Cocke et al. and assigned in common with the present application. The logic simulation machine of the Cocke et al. patent comprises a plurality of parallel basic processors which are interconnected through an interprocessor switch. The interprocessor switch provides communication not only among the basic processors which are computing engines of the logic simulation machine, each simulating the individual gates of a portion of a model of a digital logic circuit in parallel, but also between them and a control processor which provides overall control and input/output facilities of the logic simulation machine through a host computer to which the control processor is attached.

Although the logic simulation machine of the Cocke et al. patent is capable of parallel processing, the basic processors require the interprocessor switch to communicate with each other and with the host computer. The basic processors can not be directly connected to the I/O bus of the host computer without the interprocessor switch to attach the logic simulation machine to the host. In the prior art machine, each basic processor contains the current state information for only the set of gates that is being simulated by that processor. When a basic processor simulates a gate whose input includes a connection to the output of a gate being simulated by a different processor, the state information for the gate in question is transferred over the interprocessor switch. This necessarily incurs delays and prevents the full potential of the parallel processors from being more fully realised. It is accordingly an object of this invention to provide an improved logic simulation machine and method of operating digital processors to perform simulation.

According to the invention we provide a logic simulation machine comprising a plurality of simulation processors for executing logic simulation in parallel and a plurality of state memories, one associated with each simulation processor, for storing data relating to the state of a digital logic circuit being simulated, characterised in that each state memory is connected to be updated by both its associated simulation processor and by others of said simulation processors.

We further provide a method of operating a plurality of digital processors to perform logic simulation comprising the steps of storing an initial state of a digital logic circuit to be simulated in a memory unit located in each of said processors, transferring information between the processors on a simulation interface, updating the state stored in a first portion of the memory unit by one of the simulation processors, and updating the state stored in a second portion of the memory unit with the information on the simulation interface.

Such a logic simulation machine and method of logic simulation allows the simulation processors to be directly connected with a host computer or a workstation through an I/O bus of the host computer or of the workstation without any interprocessor switch so that the logic simulation machine can easily be installed in the host computer or the workstation.

In order that the invention may be well understood, a preferred embodiment thereof will now be described with reference to the accompanying drawings, in which;

Fig. 1 is a schematic block diagram of a logic simulation machine according to a preferred embodiment of the present invention with a host computer to which the machine is attached;

Fig. 2 is a schematic diagram showing contents of a block description array of Fig. 1;

Fig. 3 is a schematic diagram showing the opcode field of instructions stored in the block description array of Fig. 1;

Fig. 4 is a schematic block diagram of a simplified logic circuit model used in explaining a block description instruction and operation of the simulation processor shown in Fig. 1; and

Fig. 5 is a schematic block diagram of a portion of the current state array of the simulation processor of Fig. 1.

Best Mode for Carrying Out the Invention

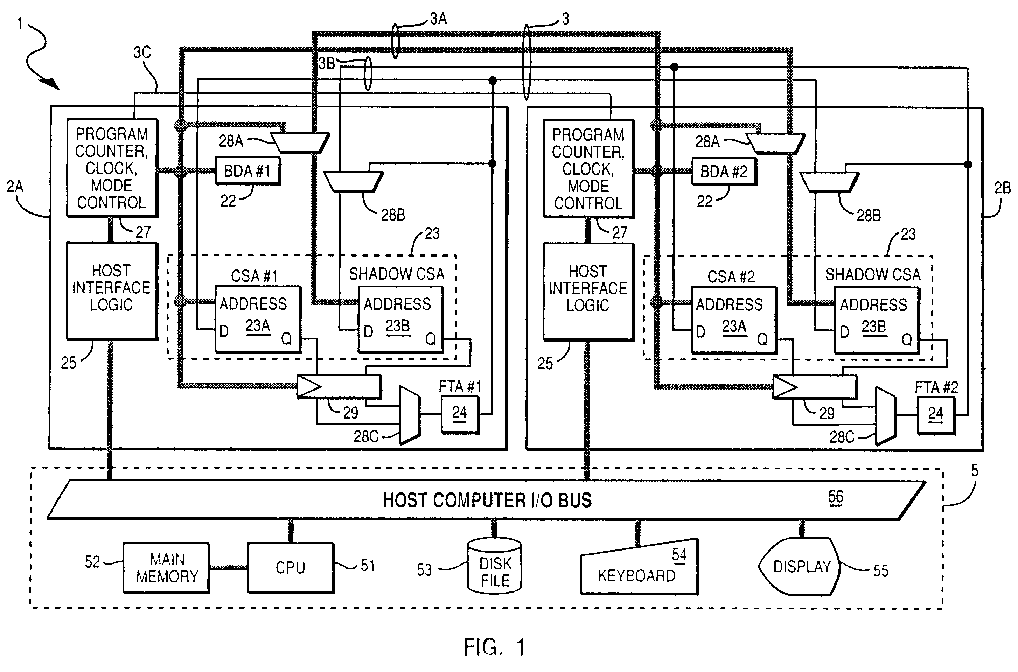

Referring to the block diagram of Fig. 1, a logic simulation machine 1 according to a preferred embodiment of the invention is explained. The logic simulation machine includes dual simulation processors 2A and 2B connected to each other in parallel through a simulation interface 3. However, more than two simulation processors may be used in other embodiments of the invention.

Simulation interface 3 between simulation processors 2A and 2B includes address lines 3A, data lines 3B and control lines 3C. Each of the simulation processors is allocated a set of address lines 3A and data lines 3B to transfer results calculated by that processor to the other simulation processor. The number of the address lines 3A and data lines 3B depends on how many bits each simulation processor needs to represent an address and a calculated result. In addition, the number of lines also depends upon the number of addresses and calculated results that will be processed simultaneously. In the illustrated dual processor embodiment, there are 48 address lines for two 24 bit addresses and 4 data lines for two 2 bit calculated results. Fewer address lines may be used if fewer bits are needed to represent an address. Control lines 3C are used by each of the simulation processors to pass clock signals and other control signals to the other simulation processor.

Host computer 5 may be a conventional engineering workstation such as an IBM RT. The host computer includes a central processing unit 51, a main memory 52, a disk file (direct access storage device) 53, a keyboard 54, a display 55, and a host I/O bus 56. Each of the simulation processors are connected to the host computer through I/O bus 56. The host computer transfers packet data to and from the simulation processors through I/O bus 56 when the simulation processors are not evaluating gates. The I/O bus is used by the host computer to load data and instructions into each of the simulation processors before simulation and to receive the results calculated by the simulation processors during and after the simulation.

The simulation processors may be integrally included with the host computer or they may be provided on one or more rectangular cards that are installed in the host computer. In addition, an extension housing may be used to connect the simulation processors to the host computer.

Each simulation processor has a first memory unit, such as a block description array 22, a second memory unit such as a current state array 23 including an active current state array 23A and a shadow current state array 23B, a logical function table 24, an input/output circuit such as a host interface logic circuit 25, and a control circuit 27 including a program counter, a clock, and control logic. In addition, each simulation processor has three multiplexors 28A, 28B, and 28C and an inverter 29.

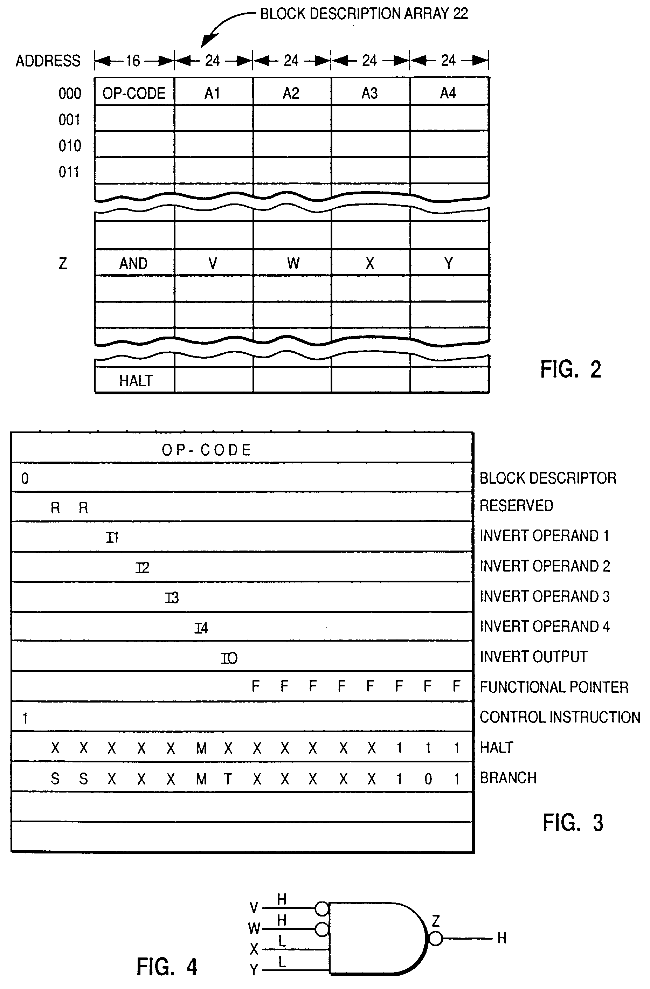

The block description array 22 is an instruction memory for the simulation processors 2A and 2B which contains all of the information necessary to specify operations of that simulation. Fig. 2 shows contents of the block description array 22. An instruction stored at one address in the array 22 contains an op-code field (16 bits), A1, A2, A3, and A4 fields (each 24 bits in this embodiment). There are two kinds of instructions determined by the op-code field as shown in Fig. 3, that is, a block description instruction having a binary zero at a first bit position of the op-code field for evaluating a gate and a control instruction having a binary one at the first bit position of the op-code field for controlling operation of that simulation processor.

As to the block description instruction, one instruction word corresponds to each logical block or gate in a model to be simulated. The instruction word's address represents a block or gate identifier. The instruction contains the op-code field, to specify a logical function of the gate, such as AND or OR, and four fields A1, A2, A3 and A4, to specify input connections or input operands of the gate. Thus, a block description instruction corresponds to a single 1-output, 4-input gate. The logical function of the gate is determined by an 8-bit function pointer FFFFFFFF in the op-code which is an index to the logical function table 24. Input/output inversion can be done by inverter 29 independent of the logical function table 24 by inversion bits I1, I2, I3, I4, and I0 in the op-code. The fields A1, A2, A3, and A4 represent addresses in the current state array 23 where the four input operands are stored. The block description instruction's address in the block description array 22 implies its output address in the current state array 23 where the calculated result is to be stored. The size of the block description array 22 depends on a desired capacity of the simulation processors 2A and 2B. In this embodiment, the array 22 can store up to 256K block description instructions.

Fig. 4 shows an example of a gate to be simulated by the simulation processor in order to illustrate the block description instruction shown at an address Z in Fig. 2. An AND gate is identified by a numeral Z which corresponds to an address in the block description array 22 where the block description instruction of the gate is stored. The AND function pointer and the inversion functions of the gate are stored in the op-code field of the instruction. Input connections V, W, X, and Y of this gate are stored in the fields A1, A2, A3 and A4 of the instruction. The current state array 23 store input operands of the gate Z at addresses V, W, X, and Y designated by the fields A1, A2, A3, and A4.

As to control instructions, the op-code field specifies control functions executed by the simulation processors. As shown in Fig. 3, Halt to stop the simulation to wait for host interaction. Branch to go to an instruction stored in the address designated by the fields A2 and A3.

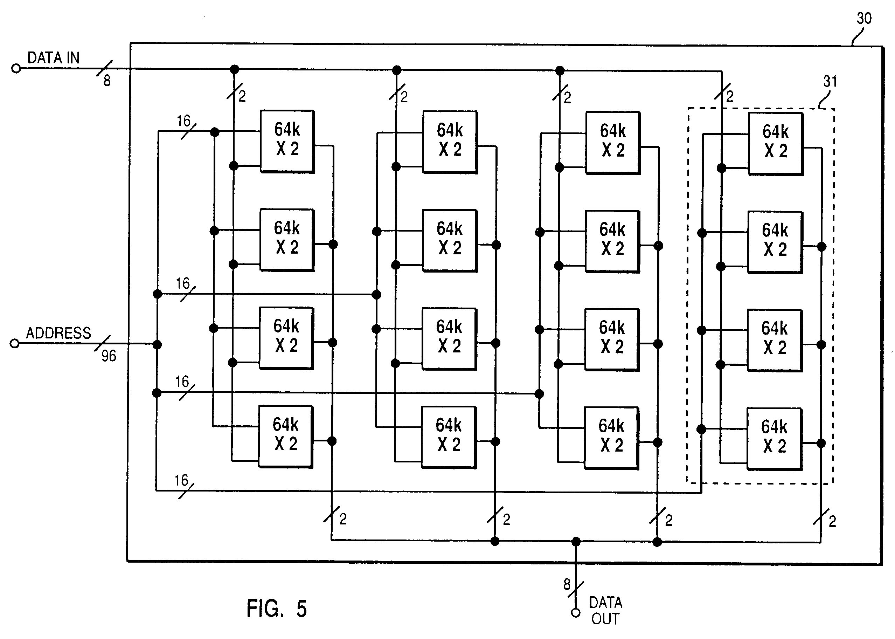

Referring to Fig. 5, a portion of a preferred current state array is explained. The portion illustrated may be used as the active current state array 23A or as the shadow current state array 23B. A current state array is a memory which stores a portion of a complete copy of current states of a whole model being simulated. The state of each block or gate is specified by 2 bits. The possible states are logical 0 (00), logical 1 (01), Undefined (10) and High Impedance (11). The current state array stores such current states of all blocks or gates of the machine being simulated.

In the computation for a given block or gate, the contents of current state array are simultaneously addressed by the four fields A1, A2, A3 and A4. It is preferred to read the current states of four different blocks or gates simultaneously. Therefore, array 31 is replicated 4 times to form current state array 30. When reading the current state array, four different addresses can be read simultaneously. When writing the current state array 30, the same address in all four arrays is written.

Referring to Fig. 1, when current state array 23 is read, block description array 22 is controlled by the control logic circuit 27 to generate an instruction with four output addresses A1, A2, A3, and A4. These addresses are then transmitted directly to the active current state array 23A and through multiplexor 28A to the shadow current state array 23B. Then, each array outputs a 2-bit operand to an inverter 29. Each of the outputted operands may be inverted by the inversion bit of the op-code in the inverter before calculation in the logical function table 24. This allows for a smaller function table array 24. When the current state array 23 is written, the board description array is controlled by the control logic circuit 27 to output one address A0. Then, the same data is written into the four arrays at the same address A0. Of course, this process could been done using a single current state array and time-slicing, but at the expense of performance.

In the illustrated embodiment, there are 256 K possible blocks or gates that can be simulated in each simulator. Therefore, the state of the model being simulated is contained in four 256K X 2 bit arrays for a total of 2 megabits in the active current state array and four 256K X 2 bit arrays for a total of 2 megabits in the shadow current state array for each simulator. Together, the active current state array and the shadow current state array have a 4 megabit capacity in the illustrated embodiment. However, the active current state array and the shadow current state array are preferably larger than the digital circuit being modelled to achieve maximum performance.

For unit delay simulation, the state of the machine being simulated needs to be saved in a "master-slave" arrangement. That is, the complete next state of the machine needs to be computed before this becomes the current state of the machine. The simplest way to implement this is with active current state array 23A and shadow current state array 23B (A and B) operating in a ping-pong arrangement. When A contains the current state, B will be used to save the next state. When B contains the current state, A is used to save the next state.

Referring back to Fig. 1, the control logic circuit 27 controls a clock so that each of the simulation processors 2A and 2B connected with the simulation interface 3 synchronously execute their operations. One simulation processor is designated as the master processor with its clock being used to synchronize the operations of all simulation processors. Control logic circuit 27 controls the program counter so that the program counter generates addresses to output instructions from the block description array 22 and addresses to write the calculated results from all of the simulation processors into the current state array 23. The control logic circuit 27 controls the control instructions, such as Branch and Halt. The control logic circuit 27 also controls the simulation processor to load the block description array 22 with instructions and the current state array 23 with initial states from the host computer 5 before simulation.

In addition, each simulation processor contains host interface 25 to transfer data and instructions between the host 5 and the simulation processors. The host interface 25 allows the user to initialize the block description array 22 and the current state array 23, and set program counters and other control information at the beginning of the simulation and tests results at the end of the simulation. It may also allow the user to read and modify the contents of the current state arrays during the simulation for enhanced simulation capability. The host interface is the subject of the copending application US Serial No. 07/502,147 filed March 30, 1990.

Referring back to Fig. 1, the operation of the logic machine 1 is explained. The host computer 5 is used to personalize the simulation processors 2A and 2B on power-on operation, load the simulation processors with instructions and data before the simulation, evaluate the results during and/or after the simulation, and interface with user. The host computer communicates with the simulation processors through the host interface 25 provided in the simulation processor of the simulation interface 3.

The host computer 5 loads the same initial states of a whole model to be simulated by the machine 1 into the current state array 23 in each of the simulation processors 2A and 2B. In the embodiment, the active current state array 23A in each simulation processor maintains one half of a complete copy of current states of the whole model being simulated during the simulation and the shadow current state array 23B maintains the other half. The host computer also loads the same functional data into the logical functional table 24.

There are two modes in operation of the simulation, running and stopped. When running mode, each simulation processor continuously steps through its block description array 22, evaluating each gate's next state, until it receives a command to stop that can be either imbedded in the block description array 22 or come from the host computer 5. In the stopped mode, no simulation is occurring, and the entire state of the logic simulation machine 1 including the current state array 23 and the block description array 22 is available for inspection and modification by the host computer 5.

In the running mode, this logic simulation machine 1 allows the multiple simulation processors to work on one simulation model to speed up simulation. In a parallel configuration, each simulation processor evaluates one gate per cycle. At the end of the cycle each simulation processor puts its result on the allocated lines of the data lines 3A in parallel and the other simulation processors update their shadow current state arrays 23B with the results from the data lines 3A.

At each cycle of the running mode, the following steps are synchronously performed in each simulation processor which is plugged into the simulation interface 3 until a Halt command is found from the block description array 22 or the host computer 5 stops the simulation.

The control logic circuit 27 sequentially increments the program counter from a start address to sequentially output instructions from the block description array 22. When the block description array 22 is addressed by the program counter, it outputs an instruction stored in the corresponding address. The op-code field indicates whether it is a block description instruction or a control instruction. If it is a block description instruction, the op-code field describes the function of the gate being evaluated. The fields A1 thru A4 specify four input connections of the gate being evaluated and correspond to addresses in the active current state array 23A and shadow current state array 23B where the current states of the input connections are stored.

The addresses A1 thru A4 are passed to the current state array 23. Four 2-bit current states that are input operands to the gate being evaluated are simultaneously fetched from the addresses designated by the fields A1 thru A4. These input operands are sent to the operand invert logic circuit 29 so that the operands are inverted if the op-code indicates before the calculation in the logical function table 24.

The input operands to the gate being evaluated are sent to the logical function table 24. This information, along with the function pointer of the op-code field describing the gate's function, serves as a pointer into the logical function table 24. The logical function table 24 is in essence a look up table, and generates a proper 2-bit output value for the gate given its present inputs. The result from the logical function table 24 is supplied to the allocated lines of the data lines 3A in order to update all the current state array 23 in the machine 1 with the result.

According to the logic simulation machine and the method of simulation of the invention, as with the Cocke et al. patent, each simulation processor simulates a set of logic gates. However, it is different in that each simulation processor maintains a complete copy of the simulated machine state, and, in place of the interprocessor switch, there is provided a simulation interface over which updates to the simulated machine state are broadcast. This information is used by each individual simulation processor to update its own copy of the simulated machine state. The simulation interface comprises individual data lines that contain the calculated results for each of the simulation processors. Thus, as a whole, it contains all of the calculated results of both simulation processors.

Although the cost of implementing a complete copy of the simulated machine state in each processor is higher than the scheme employed in the prior art, there are a number of factors that offset the disadvantage. First, the cost of memory has declined significantly in recent years. Secondly, the difficulties in compiling and scheduling a logic model to be simulated in the prior art switch-based machine do not exist in this machine. This saves significant expense in actual use of simulator.

Another characteristic that distinguishes the invention from the prior art is the way in which it connects to the host computer. It is intended that each of the simulation processors directly plug into the I/O bus of the host computer.

A further characteristic of the interaction between the host computer and the simulation processor is that the host computer will, in some configurations, perform portions of the simulation. The most common examples of this activity are modelling arrays and taking trace information.

**Claims**

1. A logic simulation machine comprising a plurality of simulation processors for executing logic simulation in parallel and a plurality of state memories, one associated with each simulation processor, for storing data relating to the state of a digital logic circuit being simulated, characterised in that each state memory is connected to be updated by both its associated simulation processor and by others of said simulation processors.

2. A machine as claimed in claim 1 in which each state memory includes an active portion arranged to be updated by the associated simulation processor and a shadow portion arranged to be updated by others of said simulation processors.

3. A logic simulation machines as claimed in claim 1 or in claim 2 further comprising a simulation interface connected to the plurality of simulation processors for transferring data between the plurality of simulation processors and the plurality of memory means.

4. A logic simulation machine as claimed in any proceeding claim, comprising: in which each simulation processor further includes a block description memory for storing instructions necessary to specify operations of the simulation processor and a logical function table connected to the block memory and the associated state memory so as to develop a result from a current instruction and the current state description.

5. A machine as claimed in any preceding claim including host computer coupled with each of the simulation processors through a host interface to initialize the simulation processors before simulation and receive the results from the simulation processors after the simulation for analysis.

6. A method of operating a plurality of digital processors to perform logic simulation comprising the steps of storing an initial state of a digital logic circuit to be simulated in a memory unit located in each of said processors, transferring information between the processors on a simulation interface, updating the state stored in a first portion of the memory unit by one of the simulation processors, and updating the state stored in a second portion of the memory unit with the information on the simulation interface.

7. A method as claimed in claim 6 comprising the steps of storing instructions to specify operations of each processors in the memory unit associated therein addressing the memory unit to output a stored instruction in each of the processors, addressing the memory unit based on such instruction to output the stored states in each of the processors, computing a result from the outputted instruction and the outputted states in a logical function table in each of the processors, updating the state stored in said first portion of the memory unit with the result from the logical function table in each of the processors, transferring the result from the logical function table on a simulation interface to each of the processors, and updating the second portion of the memory unit with the results from the simulation interface in each of the simulation processors so that such second portion in each of the simulation processors stores the current states of the digital logic circuit being simulated.

8. A method as claimed in claim 6 or claim 7 further comprising the steps of initialising the simulation processors by the host computer before simulation and sending the results from the simulation processors to the host computed after the simulation for analysis.

FIG. 1

EP 0 483 965 A2

BLOCK DESCRIPTION ARRAY 22

| ADDRESS | ←—16—→ | ←—24—→ | ←—24—→ | ←—24—→ | ←—24—→ |
|---------|---------|---------|---------|---------|---------|
| 000 | OP-CODE | A1 | A2 | A3 | A4 |
| 001 | | | | | |
| 010 | | | | | |
| 011 | | | | | |
| | | | | | |
| Z | AND | V | W | X | Y |
| | | | | | |
| | | | | | |
| | HALT | | | | |

## FIG. 2

| OP-CODE | | | | | | | | | | | | | | | |
|---|---|---|---|---|---|---|---|---|---|---|---|---|---|---|---|
| 0 | | | | | | | | | | | | | | | BLOCK DESCRIPTOR |
| | R | R | | | | | | | | | | | | | RESERVED |
| | | I1 | | | | | | | | | | | | | INVERT OPERAND 1 |
| | | | I2 | | | | | | | | | | | | INVERT OPERAND 2 |
| | | | | I3 | | | | | | | | | | | INVERT OPERAND 3 |
| | | | | | I4 | | | | | | | | | | INVERT OPERAND 4 |
| | | | | | | IO | | | | | | | | | INVERT OUTPUT |
| | | | | | F | F | F | F | F | F | F | F | F | | FUNCTIONAL POINTER |
| 1 | | | | | | | | | | | | | | | CONTROL INSTRUCTION |
| | X | X | X | X | X | M | X | X | X | X | X | 1 | 1 | 1 | HALT |
| | S | S | X | X | X | M | T | X | X | X | X | 1 | 0 | 1 | BRANCH |
| | | | | | | | | | | | | | | | |

## FIG. 3

FIG. 4

FIG. 5

EP 0 483 965 A2